(19) Europäisches Patentamt

European Patent Office

Office européen des brevets

(11) Veröffentlichungsnummer: **0 316 654 B1**

(12) **EUROPÄISCHE PATENTSCHRIFT**

(45) Veröffentlichungstag der Patentschrift: **10.06.92**

(21) Anmeldenummer: **88118213.3**

(22) Anmeldetag: **02.11.88**

(51) Int. Cl.⁵: **H05K 7/20**, H05K 7/18

(54) **Klimagerät, insbesondere für einen Schaltschrank.**

(30) Priorität: **17.11.87 DE 3738941**

(43) Veröffentlichungstag der Anmeldung:
**24.05.89 Patentblatt 89/21**

(45) Bekanntmachung des Hinweises auf die
Patenterteilung:
**10.06.92 Patentblatt 92/24**

(84) Benannte Vertragsstaaten:
**AT BE CH DE ES FR GB GR IT LI LU NL SE**

(56) Entgegenhaltungen:
**DE-A- 3 409 741**
**US-A- 3 059 736**
**US-A- 3 289 726**

**ELEKTROTECHNIK. vol. 68, no. 11, 30 Juni**
**1986, WURZBURG DE Seiten 34 - 39;**
**"SCHÄNKE UND GEHÄUSE"**

(73) Patentinhaber: **Rittal-Werk Rudolf Loh GmbH &**
**Co. KG**
**Auf dem Stützelberg**
**W-6348 Herborn(DE)**

(72) Erfinder: **Immel, Manfred**
**Hindenburgstrasse 13**
**W-6349 Mittenaar(DE)**

(74) Vertreter: **Vogel, Georg**
**Pat.-Ing. Georg Vogel Hermann-**
**Essig-Strasse 35**
**W-7141 Schwieberdingen(DE)**

**Beschreibung**

Die Erfindung betrifft ein Klimagerät, insbesondere für einen Schaltschrank, mit einem boxartigen Gehäuseunterteil und einer damit verbindbaren boxartigen Haube.

Derartige Klimageräte werden vorwiegend an Schaltschranktüren oder Seitenwänden des Schaltschrankes angebaut, wobei das gesamte Klimagerät auf der verwendeten Montagewand absteht (siehe z.B. Elektrotechnik, Band 68, Nr. 11, 30 Juni 1986, Wurzburg, DE, Seiten 34-39). Steht dieser Platz nicht zur Verfügung, dann wird das Klimagerät mittels eines zusätzlichen Montagerahmens in einen Ausschnitt der Montagewand eingesetzt, wobei es auf beiden Seiten der Montagewand teilweise vorsteht.

Es ist Aufgabe der Erfindung, ein Klimagerät der eingangs erwähnten Art zu schaffen, das sowohl an eine Montagewand angebaut, als auch in einen Ausschnitt der Montagewand eingebaut werden kann, ohne daß dafür ein zusätzlicher Montagerahmen erforderlich ist.

Diese Aufgabe wird nach der Erfindung dadurch gelöst, daß zum Anbau an eine Montagewand das Gehäuseunterteil im Boden und die Montagewand mit Verbindungselementen zum Verschrauben des Gehäuseunterteils an der Montagewand versehen sind, daß das Gehäuseunterteil und die Haube an den einander zugekehrten offenen Seiten nach innen gerichtete, umlaufende Abkantungen der Seitenwände aufweisen, daß die Abkantungen des Gehäuseunterteils der Haube zugekehrt mit fest angebrachten Gewindebolzen versehen sind, auf die die mit entsprechenden Bohrungen versehenen Abkantungen der Haube aufschiebbar sind, daß zwischen die Abkantungen des Gehäuseunterteils und der Haube beim Anbau des Klimagerätes an die Montagewand ein umlaufender Dichtungsstreifen eingebracht ist, während beim Einbau des Klimagerätes in einen Ausschnitt der Montagewand zwischen die Abkantungen des Gehäuseunterteils und den Dichtungsstreifen zunächst die um den Ausschnitt mit Befestigungsbohrungen versehene Montagewand mittels Muttern auf den Gewindebolzen festgelegt ist, und daß die Haube mittels unverlierbar in der Haube gehaltenen, axial begrenzt verstellbaren Befestigungsbolzen mit Gewindeaufnahme, die auf die Gewindebolzen aufschraubbar sind, mit dem Gehäuseunterteil verbunden ist.

Mit dieser Ausgestaltung von Gehäuseunterteil und Haube ist wahlweise sowohl der Anbau an eine Montagewand, als auch ein Einbau in den Ausschnitt der Montagewand möglich, ohne daß dafür ein zusätzlicher Montagerahmen erforderlich ist. Außerdem ist in jedem Fall das Klimagerät im Bereich der Verbindung zwischen dem Gehäuseunterteil und der Haube eindeutig abgedichtet, so daß seine Funktion nicht beeinträchtigt ist. Die Haube läßt sich unabhängig vom Anbau oder Einbau abnehmen, ohne daß das Klimagerät von der Montagewand gelöst wird. Dies ist für die Wartung des Klimagerätes von Bedeutung.

Ist nach einer Ausgestaltung vorgesehen, daß die Montagewand bei Anbau neben den Befestigungsbohrungen für die Verbindungselemente zwei Lüftungsöffnungen aufweist, dann ist für diese Verbindungsart der Luftaustausch zwischen dem Schaltschrank und dem Klimagerät möglich.

Eine einfache Verschraubung des Gehäuseunterteils mit der Montagewand ergibt sich nach einer Ausgestaltung dadurch, daß die Verbindungselemente im Boden des Gehäuseunterteils als Gewindeniet ausgebildet sind, in die Gewindestifte eingeschraubt sind, und daß die Montagewand mit den Befestigungsbohrungen auf die Gewindestifte aufgeschoben und mittels Muttern darauf gehalten ist.

Die Verbindung zwischen dem Gehäuseunterteil und der Montagewand wird dadurch eindeutig abgedichtet, daß beim Anbau an die Montagewand zwischen die Montagewand und das Gehäuseunterteil ein umlaufender Dichtungsstreifen eingebracht ist.

Ist weiterhin vorgesehen, daß die Seitenwände des Gehäuseunterteils im Anschluß an die nach innen gerichteten Abkantungen nach außen und parallel zu den Seitenwänden gerichtete Endabschnitte aufweisen, die den Verbindungsbereich zwischen dem Gehäuseunterteil und der Haube überdecken, dann bilden die Endabschnitte einen Rahmen, der das Einbaumaß, d.h. die Abmessungen des Ausschnittes in der Montagewand, bestimmen. Es ist daher vorgesehen, daß der Ausschnitt der Montagewand beim Einbau auf das durch die Außenabmessungen der Endabschnitte der Seitenwände des Gehäuseunterteils angepaßt ist und daß die um den Ausschnitt angeordneten Befestigungsbohrungen der Montagewand auf die Anordnung und Verteilung der Gewindebolzen an den Abkantungen der Seitenwände des Gehäuseunterteils abgestimmt sind.

Beim Anbau des Klimagerätes sind die Befestigungsbohrungen der Montagewand auf die Anordnung und Verteilung der als Gewindeniet ausgebildeten Verbindungselemente im Boden des Gehäuseunterteils abgestimmt. Dabei ist vorgesehen, daß die als Gewindeniet ausgebildeten Verbindungselemente unverlierbar und unverdrehbar in Bohrungen des Bodens des Gehäuseunterteils festgelegt sind, um die Gewindestifte leicht einschrauben zu können. Die Verbindung kann auch mittels einer Kopfschraube erfolgen.

Die unverlierbare, axial begrenzt verstellbare, jedoch drehbare Anordnung der Befestigungsbolzen in der Haube wird nach einer Ausgestaltung dadurch erreicht, daß die Befestigungsbolzen der Haube in U-förmigen Führungsbügeln gehalten sind, die auf den Innenseiten der Seitenwände der Haube angebracht sind, wobei die Befestigungsbolzen in Bohrungen der Seitenschenkel der Führungsbügel geführt und ihre axiale Verstellbarkeit mittels auf den Befestigungsbolzen aufgebrachten Sicherungselementen begrenzt ist, und daß in die dem Gehäuseunterteil zugekehrten Stirnseiten der Gewindebolzen die Gewindeaufnahmen zur Aufnahme der Gewindebolzen des Gehäuseunterteils eingebracht sind. Für die Bedienung dieser Befestigungsbolzen ist vorgesehen, daß die mit einem Schlitz versehenen, der Deckwand der Haube zugekehrten Enden der Befestigungsbolzen über Bohrungen der Deckwand zugänglich sind.

Die Einbauten des Klimagerätes sind so verteilt, daß alle Komponenten, wie Kompressor, Verflüssiger, Verdampfer, Ventilatoren usw. in dem Gehäuseunterteil angeordnet sind und daß in der Haube Elemente zur Luftführung und Luftreinigung, wie Filtermatte und dgl., untergebracht sind.

Das Gehäuseunterteil nimmt die Komponenten auf, die miteinander verbunden bzw. gekoppelt werden, während die Haube mit ihren Elementen keine geschaltete oder hergestellte Verbindung zu den Komponenten des Gehäuseunterteils benötigt, so daß die Haube nach wie vor leicht vom Gehäuseunterteil abgenommen werden kann.

Die Erfindung wird anhand von in den Zeichnungen dargestellten Ausführungsbeispielen näher erläutert. Es zeigt:

Fig. 1 in Seitenansicht den Anbau eines Klimagerätes aus Gehäuseunterteil und Haube an eine Montagewand,

Fig. 2 das Lochbild der Montagewand für den Anbau des Klimagerätes,

Fig. 3 in Seitenansicht den halben Einbau eines Klimagerätes aus Gehäuseunterteil und Haube in einen Ausschnitt einer Montagewand,

Fig. 4 das Lochbild der Montagewand für den Einbau des Klimagerätes,

Fig. 5 in Einzelheiten die Verbindung zwischen der Montagewand und dem Gehäuseunterteil sowie die Verbindung zwischen dem Gehäuseunterteil und der Haube beim Anbau des Klimagerätes an die Montagewand,

Fig. 6 in Einzelheiten die Verbindung zwischen dem Gehäuseunterteil, der Montagewand und der Haube beim Einbau des Klimagerätes in einen Ausschnitt der Montagewand,

Fig. 7 in Seitenansicht den vollständigen Einbau eines Klimagerätes aus Gehäuseunterteil und einer in ein rahmenartiges Teil und eine getrennte Deckwand unterteilten Haube in einen Ausschnitt einer Montagewand,

Fig. 8 das Lochbild der Montagewand für den vollständigen Einbau des Klimagerätes und

Fig. 9 in Einzelheiten die Verbindung zwischen dem Gehäuseunterteil und dem rahmenartigen Teil der Haube sowie zwischen dem rahmenartigen Teil und der getrennten Deckwand der Haube.

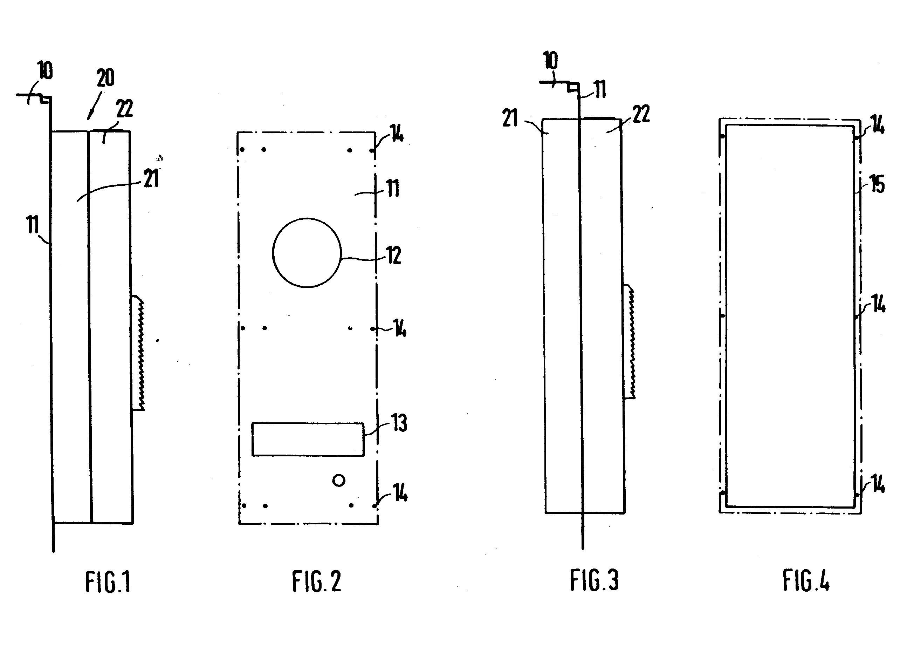

Die Seitenansicht nach Fig. 1 zeigt den Schaltschrank 10 nur im Bereich der Montagewand 11, die die Schaltschranktür oder eine Seitenwand des Schrankkorpus sein kann. Das Klimagerät 20 besteht aus dem Gehäuseunterteil 21 und der Haube 22. Im Gehäuseunterteil 21 sind alle Komponenten, wie Kompressor, Verflüssiger, Verdampfer, Ventilatoren usw. untergebracht, die miteinander verschaltet und gekoppelt sind. In der Haube 22 sind nur Elemente, die der Luftführung und Luftreinigung, wie Filtermatte und dgl., angeordnet, so daß die Haube 22 leicht von dem Gehäuseunterteil 21 abgenommen werden kann. Das Klimagerät 20 steht beim Anbau mit den ganzen Abmessungen an der Montagewand 11 ab.

In Fig. 2 ist das Lochbild für den Anbau des Klimagerätes 10 gezeigt. Die Befestigungsbohrungen 14 erlauben Schraubverbindungen mit Verbindungselementen des Gehäuseunterteils 21, wie noch gezeigt wird. Zu beachten ist, daß die Anordnung und Verteilung der Verbindungselemente an der Montageplatte 11 und dem Boden des Gehäuseunterteils 21 aufeinander abgestimmt und ausgerichtet sind. Die Lüftungsöffnungen 12 und 13 in der Montageplatte 11 ermöglichen den Luftaustausch zwischen dem Schaltschrank 10 und dem Klimagerät 20.

Die Seitenansicht nach Fig. 3 zeigt den Schaltschrank 10 ebenfalls nur im Bereich der Montagewand 11, die wiederum die Schaltschranktür oder eine Seitenwand des Schrankkorpus sein kann. Bei dem Einbau des Klimagerätes 20 in den Ausschnitt 15 der Montageplatte 11 kommt das Gehäuseunterteil 21 im wesentlichen auf die Innenseite des Schaltschrankes 10 zu liegen, während die Haube 22 auf der Außenseite der Montagewand 11 absteht. Die Befestigungsbohrungen 14 sind um den Ausschnitt 15 in der Montageplatte 11 angeordnet und in der Anordnung und Verteilung auf Verbindungselemente abgestimmt, die im Verbindungsbereich zwischen dem Gehäuseunterteil 21 und der Haube 22 vorgesehen sind, wie noch gezeigt wird.

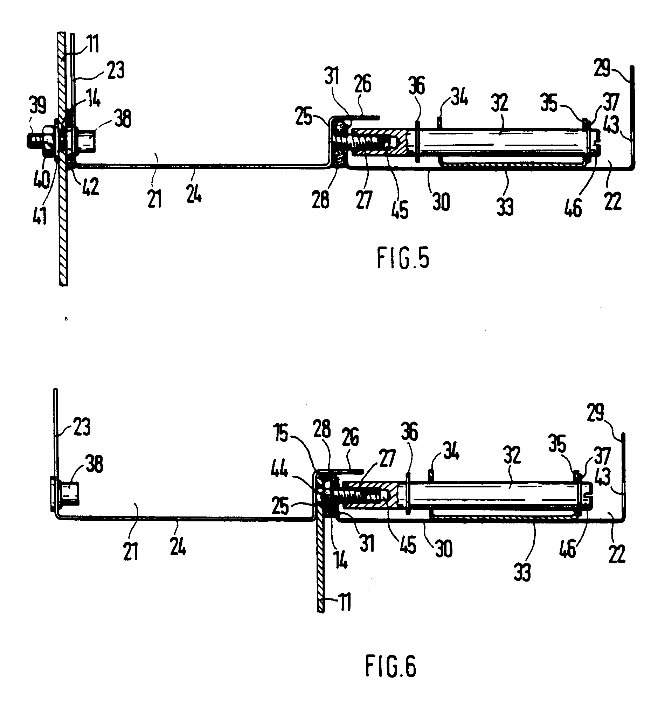

Anhand des Teilschnittes nach Fig. 5 wird der Anbau des Klimagerätes 10 an die Montageplatte 11 näher erläutert. Im Boden 23 des boxartigen Gehäuseunterteils 21 sind als Verbindungselemente Gewindenieten 38 vorgesehen, die in Bohrungen unverlierbar und unverdrehbar festgelegt sind. Die Gewindenieten 38 sind im Bereich der Seitenwände 24 des Gehäuseunterteils 21 entsprechend dem Lochbild der Befestigungsbohrungen 14 der Fig. 2 verteilt, so daß das Gehäuseunterteil 21 mehrfach mit der Montageplatte 11 verschraubt werden kann.

Der Dichtungsstreifen 42 zwischen der Montageplatte 11 und dem Boden 23 des Gehäuseunterteils 21 verläuft über alle Verbindungsstellen umlaufend und bringt eine eindeutige Abdichtung zwischen der Montageplatte 11 und dem Gehäuseunterteil 21. In die Gewindeniete 38 werden Gewindestifte 39 eingeschraubt, die durch die Befestigungsbohrungen 14 der Montageplatte 11 hindurchgeführt werden. Über die Unterlagscheibe 41 und die Mutter 40 wird die Schraubverbindung vervollständigt, so daß das Klimagerät 20 an der Montageplatte 11 gehalten ist. Anstelle der Gewindestifte 39 und der Muttern 40 können auch Kopfschrauben verwendet werden, die vom Schrankinnenraum aus durch die Befestigungsbohrungen 14 hindurch in die Gewindenieten 38 einschraubbar sind.

Die Seitenwände 24 und 30 von Gehäuseunteil 21 und Haube 22 sind umlaufend nach innen abgekantet, wie die Abkantungen 25 und 31 zeigen. Auf der der Haube 22 zugekehrten Seite der Abkantungen 25 des Gehäuseunterteils 21 sind Gewindebolzen 27 befestigt, z.B. aufgeschweißt, deren Anordnung und Verteilung auf das Lochbild der Befestigungsbohrungen 14 der Montageplatte 11 nach Fig. 4 abgestimmt ist. Die Abkantungen 31 der Seitenwände 30 der Haube 22 tragen entsprechend verteilt Bohrungen, so daß die Abkantungen 31 auf die Gewindebolzen 27 aufgeschoben werden können. Zwischen den Abkantungen 25 und 31 verläuft umlaufend der Dichtungsstreifen 28, der den Verbindungsbereich zwischen dem Gehäuseunterteil 21 und der Haube 22 abdichtet. Gehalten wird die Haube 22 mittels Befestigungsbolzen 32, die auf der dem Gehäuseunterteil 21 zugekehrten Stirnseite mit Gewindeaufnahmen 45 versehen und darüber auf die Gewindebolzen 27 aufschraubbar sind. Die Befestigungsbolzen 32 sind in den Seitenschenkeln 34 und 35 der U-förmigen Führungsbügel 33 drehbar und axial begrenzt verstellbar geführt, wobei die auf den Befestigungsbolzen 32 aufgebrachten Sicherungselemente 36 und 37 die Verstellbewegung begrenzen. Die Bedienung der Befestigungsbolzen 32 erfolgt über die Bohrungen 43 in der Deckwand 29 der Haube 22 und das mit dem Schlitz versehene Ende 46. Die Verteilung der Befestigungsbolzen 32 ist auf die Verteilung der Gewindebolzen 27 abgestimmt und ausgerichtet. Die Führungsbügel 33 sind auf den Innenseiten der Seitenwände 30 der Haube 22 befestigt.

Die Abkantungen 25 des Gehäuseunterteils 21 gehen in umlaufende Endabschnitte 26 über, die nach außen abgekantet sind und den Verbindungsbereich zwischen dem Gehäuseunterteil 21 und der Haube 22 überdecken. Diese Endabschnitte 26 bilden eine Art Rahmen, dessen Außenabmessungen den Ausschnitt in der Montageplatte 11 für einen Einbau gemäß Fig. 3 bestimmen.

In Fig. 6 ist im Teilschnitt diese Einbauart erkennbar. Das Gehäuseunterteil 21 wird über die Gewindebolzen 27, die durch die Befestigungsbohrungen 14 der Montageplatte 11 gemäß Fig. 4 hindurchgeführt sind, und die Muttern 44 auf der Innenseite der Montageplatte 11 festgelegt. Die Befestigung der Haube 22 an dem Gehäuseunterteil 21 erfolgt wie beim Anbau nach Fig. 5 über die Gewindebolzen 27 und die Befestigungsbolzen 32. Das Lochbild der Befestigungsbohrungen 14 der Montageplatte 11 mit dem Ausschnitt 15 entspricht der Verteilung der Gewindebolzen 27 und der Befestigungsbolzen 32. Die Abdichtung des Verbindungsbereiches zwischen dem Gehäuseunterteil 21 und der Haube 22 erfolgt über den umlaufenden Dichtungsstreifen 28, der jetzt zwischen der mit den Muttern 44 gehaltenen Montageplatte 11 und den Abkantungen 31 der Seitenwände 30 der Haube 22 angeordnet ist.

Das Gehäuseunterteil 21 mit den Gewindenieten 38 und die Gewindebolzen 27 an den Abkantungen 25 des Gehäuseunterteils 21 erlauben in Verbindung mit den Befestigungsbolzen 32 der Haube 22 einen wahlweisen Anbau oder Einbau des Klimagerätes, wobei das Gehäuseunterteil 21 stets mit der Montageplatte 11 verbunden bleiben kann, wenn zur Wartung die Haube 22 des Klimagerätes 20 abgenommen wird.

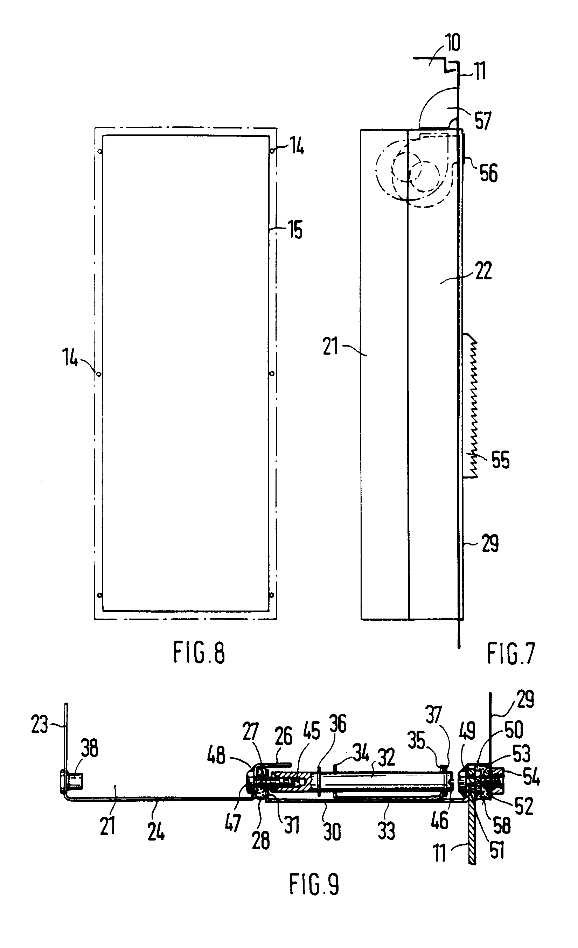

Die Seitenansicht nach Fig. 7 zeigt, daß das Klimagerät auch vollständig eingebaut werden kann, so daß nur die Deckwand 29 mit einem Rand an der Außenseite der Montagewand 11 vorsteht. Der Luftkreislauf kann vom Eingang 55 dabei wahlweise über die Deckwand 29 oder die Montagewand 11 zum Ausgang 56 oder 57 führen, wie die gestrichelt eingezeichneten Gebläse andeuten.

Wie Fig. 8 zeigt, bleibt das Lochbild in der Montagewand 11 dasselbe wie beim halben Einbau des Klimagerätes nach den Fig. 3 und 4.

Damit bei der Wartung das Klimagerät mit seinen Komponenten an der Montagewand 11 befestigt bleiben kann, wird die Deckwand 29 von der Haube 22 getrennt, so daß sie unabhängig vom restlichen Teil der Haube 22 abgenommen werden kann. Die Verbindung zwischen dem Gehäuseunterteil 21 und dem rahmenartigen Teil der Haube 22 bleibt unverändert, wie beim Anbau des Klimagerätes nach den Fig. 1, 2 und 5. Der Deckwand 29 zugekehrt ist der rahmenartige Teil der Haube 22 mit der Z-förmigen Abkantung versehen, wobei die nach innen gerichtete Abkantung 49 senkrecht zur Rahmenwand steht und in den Endabschnitt 50 übergeht, der parallel zur Rahmenwand gerichtet ist und die neue Verbindungsstelle zwischen dem rahmenartigen Teil und der getrennten Deckwand 29 der Haube 22 überdeckt. An der umlaufenden Abkantung 49 sind die Gewindestifte 51 festgemacht, vorzugsweise angeschweißt. Die Gewindestifte 51 können Kopfschrauben sein, die durch Bohrungen der Abkantung 49 geführt und mit dem Kopf mit dieser verschweißt sind. Dies ist anhand der Gewindebolzen 27 mit dem Kopf 47 und der Schweißnaht 48 gezeigt. Die Gewindestifte 51 können in gleicher Weise an der Abkantung angeschweißt sein, sie stehen an der Abkantung 49 in Richtung zur Deckwand 29 ab. Die mit dem umlaufenden, abgekanteten Rand 58 versehene Deckwand 29 trägt in der Anordnung und Verteilung der Gewindestifte 51 an der Abkantung 49 Bohrungen, durch die die Gewindestifte 51 auf die Außenseite der Deckwand 29 geführt werden können. Vorher werden die Gewindestifte 51 aber durch die Bohrungen 14 der Montagewand 11 geführt, so daß mittels der Muttern 52, die auf die Gewindestifte 51 aufgeschraubt werden, das Gehäuseunterteil 21 und der rahmenartige Teil der Haube 22 an der Montagewand 11 befestigt ist. Zwischen der Montagewand 11 und der Innenseite der Deckwand 29 wird das umlaufende Dichtungsband 53 angeordnet, bevor die Deckwand 29 mittels der Muttern 54 mit der Montagewand 11 verbunden wird. Die Deckwand 29 kann nach dem Lösen der Muttern 54 abgenommen werden, ohne daß der rahmenartige Teil der Haube 22 und das damit verbundene Gehäuseunterteil 21 von der Montagewand 11 gelöst werden müssen. Dies erleichtert die Wartung des vollständig eingebauten Klimagerätes.

**Patentansprüche**

1. Klimagerät, insbesondere für einen Schaltschrank, mit einem boxartigen Gehäuseunterteil und einer damit verbindbaren boxartigen Haube,
dadurch gekennzeichnet,
daß zum Anbau an eine Montagewand (11) das Gehäuseunterteil (21) im Boden (23) und die Montagewand (11) mit Verbindungselementen zum Verschrauben des Gehäuseunterteils (21) an der Montagewand (11) versehen sind,
daß das Gehäuseunterteil (21) und die Haube (22) an den einander zugekehrten offenen Seiten nach innen gerichtete, umlaufende Abkantungen (25,31) der Seitenwände (24,30) aufweisen,
daß die Abkantungen (25) des Gehäuseunterteils (21) der Haube (22) zugekehrt mit fest angebrachten Gewindebolzen (27) versehen sind, auf die die mit entsprechenden Bohrungen versehenen Abkantungen (31) der Haube (22) aufschiebbar sind,
daß zwischen die Abkantungen (25,31) des Gehäuseunterteils (21) und der Haube (22) beim Anbau des Klimagerätes (10) an die Montagewand (11) ein umlaufender Dichtungsstreifen (28) eingebracht ist, während beim Einbau des Klimagerätes (10) in einen Ausschnitt (15) der Montagewand (11) zwischen die Abkantungen (25) des Gehäuseunterteils (21) und den Dichtungsstreifen (28) zunächst die um den Ausschnitt (15) mit Befestigungsbohrungen (14) versehene Montagewand (11) mittels Muttern (44) auf den Gewindebolzen (27) festgelegt ist, und
daß die Haube (22) mittels unverlierbar in der Haube (22) gehaltenen, axial begrenzt verstellbaren Befestigungsbolzen (32) mit Gewindeaufnahme (45), die auf die Gewindebolzen (27) aufschraubbar sind, mit dem Gehäuseunterteil (21) verbunden ist.

2. Klimagerät nach Anspruch 1,
dadurch gekennzeichnet,
daß die Montagewand (11) bei Anbau neben den Befestigungsbohrungen (14) für die Verbindungselemente zwei Lüftungsöffnungen (12,13) aufweist.

3. Klimagerät nach Anspruch 1 oder 2,
dadurch gekennzeichnet,
daß die Verbindungselemente im Boden (23) des Gehäuseunterteils (21) als Gewindeniet (38) ausgebildet sind, in die Gewindestifte (39) eingeschraubt sind, und
daß die Montagewand (11) mit den Befestigungsbohrungen (14) auf die Gewindestifte (39) aufgeschoben und mittels Muttern (40) darauf gehalten ist.

4. Klimagerät nach Anspruch 3,
dadurch gekennzeichnet,
daß beim Anbau an die Montagewand (11) zwischen die Montagewand (11) und das Gehäuseunterteil (21) ein umlaufender Dichtungsstreifen (42) eingebracht ist.

5. Klimagerät nach einem der Ansprüche 1 bis 4,
dadurch gekennzeichnet,
daß die Seitenwände (24) des Gehäuseunterteils (21) im Anschluß an die nach innen gerichteten Abkantungen (25) nach außen und parallel zu den Seitenwänden (25) gerichtete Endabschnitte (26) aufweisen, die den Verbindungsbereich zwischen dem Gehäuseunterteil (21) und der Haube (22) überdecken.

6. Klimagerät nach einem der Ansprüche 1 bis 5,
dadurch gekennzeichnet,
daß der Ausschnitt (15) der Montagewand (11) beim Einbau auf das durch die Außenabmessungen der Endabschnitte (26) der Seitenwände (24) des Gehäuseunterteils (21) angepaßt ist und
daß die um den Ausschnitt (15) angeordneten Befestigungsbohrungen (14) der Montagewand (11) auf die Anordnung und Verteilung der Gewindebolzen (27) an den Abkantungen (25) der Seitenwände (24) des Gehäuseunterteils (21) abgestimmt sind.

7. Klimagerät nach einem der Ansprüche 1 bis 6, dadurch gekennzeichnet, daß beim Anbau die Befestigungsbohrungen (14) der Montagewand (11) auf die Anordnung und Verteilung der als Gewindeniet (38) ausgebildeten Verbindungselemente im Boden (23) des Gehäuseunterteils (21) abgestimmt sind.

8. Klimagerät nach Anspruch 7, dadurch gekennzeichnet, daß die als Gewindeniet (38) ausgebildeten Verbindungselemente unverlierbar und unverdrehbar in Bohrungen des Bodens (23) des Gehäuseunterteils (21) festgelegt sind.

9. Klimagerät nach einem der Ansprüche 1 bis 8, dadurch gekennzeichnet, daß die Befestigungsbolzen (32) der Haube (22) in U-förmigen Führungsbügeln (33) gehalten sind, die auf den Innenseiten der Seitenwände (30) der Haube (22) angebracht sind, wobei die Befestigungsbolzen (32) in Bohrungen der Seitenschenkel (34,35) der Führungsbügel (33) geführt und ihre axiale Verstellbarkeit mittels auf den Befestigungsbolzen (32) aufgebrachten Sicherungselementen (36,37) begrenzt ist, und daß in die dem Gehäuseunterteil (21) zugekehrte Stirnseiten der Gewindebolzen (32) die Gewindeaufnahmen (45) zur Aufnahme der Gewindebolzen (27) des Gehäuseunterteils (21) eingebracht sind.

10. Klimagerät nach Anspruch 9, dadurch gekennzeichnet, daß die mit einem Schlitz versehenen, der Deckwand (29) der Haube (22) zugekehrten Enden (46) der Befestigungsbolzen (32) über Bohrungen (43) der Deckwand (29) zugänglich sind.

11. Klimagerät nach einem der Ansprüche 1 bis 10, dadurch gekennzeichnet, daß alle Komponenten, wie Kompressor, Verflüssiger, Verdampfer, Ventilatoren usw. in dem Gehäuseunterteil (21) angeordnet sind und daß in der Haube (22) Elemente zur Luftführung und Luftreinigung, wie Filtermatte und dgl., untergebracht sind.

12. Klimagerät nach einem der Ansprüche 1 bis 11, dadurch gekennzeichnet, daß zum vollständigen Einbau in den Ausschnitt (15) der Montagewand (11) die Deckwand (29) mit abgekantetem Rand (58) als von der Haube (22) getrenntes Teil ausgebildet ist, daß der als Rahmen verbleibende Teil der Haube (22) der Deckwand (29) zugekehrt eine umlaufende, nach innen gerichtete Abkantung (49) aufweist, daß an der Abkantung (49) in Richtung zur Deckwand (29) abstehende Gewindestifte (51) angebracht sind, auf denen die mit Bohrungen (14) und dem entsprechenden Ausschnitt (15) versehene Montagewand (11) aufgeschoben und mit Muttern (52) festgelegt ist, daß die Deckwand (29) auf die Gewindestifte (51) ausgerichtete Bohrungen aufweist, durch die die Gewindestifte (51) auf die Außenseite der Deckwand (29) geführt sind, daß zwischen der Abkantung (49) der Montagewand (11) und der Innenseite der Deckwand (29) ein umlaufendes Dichtungsband (53) angeordnet ist, und daß die Deckwand (29) mittels Muttern (54), die auf die aus den Bohrungen der Deckwand (29) ragenden Abschnitte der Gewindestifte (51) aufgeschraubt sind, mit dem restlichen Rahmen der Haube (22) und der Montagewand (11) verbunden ist (Fig. 9).

13. Klimagerät nach einem der Ansprüche 1 bis 12, dadurch gekennzeichnet, daß als Gewindebolzen (27) bzw. Gewindestifte (51) Kopfschrauben verwendet sind, die durch Bohrungen der Abkantung (25,49) des Gehäuseunterteils (21) bzw. der Haube (22) eingeführt und mit dem Kopf auf der der Haube (22) bzw. der Deckwand (29) abgekehrten Seite mit dieser verschweißt ist.

14. Klimagerät nach Anspruch 12, dadurch gekennzeichnet, daß die Abkantung (49) des rahmenartigen Teils der Haube (22) einen Endabschnitt (50) aufweist, der parallel zu den Rahmenseiten ausgerichtet ist und den Verbindungsbereich zwischen dem rahmenartigen Teil der Haube (22) und der Deckwand (29) überdeckt.

**Claims**

1. Air conditioner, especially for an electrical cabinet, comprising a box-shaped lower part of the housing and a box-shaped cover which can be connected with it, characterized thereby,

that for panel-mounting (11) purposes the lower part of the housing (21) is provided with fasteners in the bottom (23) and the mounting panel (11) is also provided with fasteners for screwing the housing lower part (21) onto the mounting panel (11),
that the lower part of the housing (21) and the cover (22) are provided on their open sides facing each other, with continuous edges (25,31) of the lateral panels (24,30) which are directed towards the inner side,
that the edges (25) of the lower part of the housing (21) are directed towards the cover (22) and provided with unremovable threaded pins (27) on which the edges (31) of the cover (22) can be slipped on by means of their related bores,
that between the edges (25,31) of the lower part of the housing (21) and the cover (22) a continuous seal strip (28) is mounted when the air conditioner (10) has to be mounted on the mounting panel (11),
whereas for the installation of the air conditioner (10) into a cut-out (15) of the mounting panel (11) between the edges (25) of the lower part of the housing (21) and the seal strip (28), this mounting panel (11) provided with fastening bores (14) located around the cut-out (15) is first fixed on the threaded pins (27) by means of nuts (44), and
that the cover (22) is connected with the lower part of the housing (21) by means of fastening bolts (32) with threaded receptacles (45) which are unremovably mounted on the cover (22) and axially limited in their adjustment and which can be screwed onto the threaded pins (27).

2.   Air conditioner according to claim 1,
characterized thereby,
that for installation purposes the mounting panel (11) has two vent openings (12,13) located next to the fastening bores (14) for the fasteners.

3.   Air conditioner according to claim 1 or 2,
characterized thereby,
that the fasteners in the bottom (23) of the lower part of the housing (21) are shaped as threaded rivets (38), in which the threaded pins (39) are screwed, and that the mounting panel (11) is slipped onto the threaded pins (39) with its fastening bores (14) and fixed there by means of nuts (40).

4.   Air conditioner according to claim 3,
characterized thereby,
that for installation on the mounting panel (11) a continuous seal strip (42) is mounted between the mounting panel (11) and the lower part of the housing (21).

5.   Air conditioner according to one of the claims 1 to 4,
characterized thereby,
that the lateral panels (24) of the lower part of the housing are provided with end sections (26) directed outward and parallel to the lateral panels (25) after the inner edges (25) which cover the connection area between the lower part of the housing (21) and the cover (22).

6.   Air conditioner according to one of the claims 1 to 5,
characterized thereby,
that the cut-out (15) of the mounting panel (11) is matched by means of the outer dimensions of the end sections (26) of the lateral panels (24) of the lower part of the housing (21) and
that the fastening bores (14) located around the cut-out (15) of the mounting panel (11) is matched to the location and the distribution of the threaded pins (27) mounted on the edges (25) of the lateral panels (24) of the lower part of the housing (21).

7.   Air conditioner according to one of the claims 1 to 6,
characterized thereby,
that for installation, the fastening bores (14) of the mounting panel (11) are matched to the location and the distribution of the fasteners in the bottom (23) of the lower part of the housing (21), which are shaped as threaded rivets (38).

8.   Air conditioner according to claim 7,
characterized thereby,
that the fasteners, which are shaped as threaded rivets (38) are unremovably and unrotatably fixed in the bores of the bottom (23) of the lower part of the housing (21).

9.   Air conditioner according to one of the claims 1 to 8,
characterized thereby,
that the fastening bolts (32) of the cover (22) are retained in U-shaped guiding shackles (33) located on the inner sides of the lateral panels (30) of the cover (22), whereby the fastening bolts (32) are guided in bores of the legs (34,35) of these guiding shackles (33) and their axial regulation being limited by means of stoppers (36,37) located on the fastening bolts (32), and
that the faces of the threaded bolts (32) directed towards the lower part of the housing (21) are provided with threaded receptacles (45) for the location of the threaded pins (27) of the lower part of the housing (21).

**10.** Air conditioner according to claim 9,
characterized thereby,
that the slotted ends (46) of the fastening bolts (32) facing the upper panel (29) of the cover (22), are accessible through bores (43) bored in that upper panel (29).

**11.** Air conditioner according to one of the claims 1 to 10,
characterized thereby,
that all components such as compressor, condenser, vaporizer, fans etc. are located in the lower part of the housing (21) and
that the cover (22) accommodates elements for air conduction and air cleaning such as filter mat and similar.

**12.** Air conditioner according to one of the claims 1 to 11,
characterized thereby,
that for the complete installation into the cut-out (15) of the mounting panel (11) the cover panel (29) with bent edge (58) is provided as part separated from the cover (22),
that the part of the cover (22) remaining as frame is provided with a continuous edge (49) directed inside towards the cover panel (29),
that the edge (49) is provided with threaded pins (51) protuding towards the cover panel (29) on which the mounting panel (11) with the respective cut-out (15) and bores (14) is slipped on and fixed by means of the nuts (52),
that the cover panel (29) is provided with bores facing the threaded pins (51), through which the threaded pins (51) go to the outside of the cover panel (29),
that between the edge (49) of the mounting panel (11) and the inner side of the cover panel (29) a continuous sealing (53) is mounted, and
that the cover panel (29) is connected with the remaining frame of the cover (22) and the mounting panel (11) (Fig.9) by means of nuts (54), which are screwed onto the threaded pins (51) protuding from the bores of the cover panel (29).

**13.** Air conditioner according to one of the claims 1 to 12,
characterized thereby,
that one use cap screws as threaded pins (51) or threaded bolts (27) which are introduced into bores of the edge (25,49) of the lower part of the housing (21) or the cover (22) and welded with their caps on that side which is turned away from the cover (22) or the cover panel (29).

**14.** Air conditioner according to claim 12,
characterized thereby,
that the edge (49) of the frame-like part of the cover (22) is provided with an end section (50) directed parallel to the frame sides and covering the connection area between the framelike part of the cover (22) and the cover panel (29).

**Revendications**

**1.** Appareil de climatisation, notamment pour une armoire électrique, avec un soubassement de boîtier en forme de caisson et avec un capot pouvant être relié au soubassement, également en forme de caisson,
caractérisé
en ce qu'aux fins de la pose sur une paroi de montage (11), tant le fond (23) du soubassement (21) du boîtier que la paroi de montage (11) sont dotés d'éléments de liaison, en vue du vissage du soubassement (21) du boîtier sur la paroi de montage (11),
en ce que le soubassement (21) du boîtier et le capot (21) présentent, sur les côtés ouverts se faisant face, des ailes coudées périphériques (25, 31) orientées vers l'intérieur des parois latérales (24, 30),
en ce que les ailes coudées (25) du soubassement (21) du boîtier sont dotées de boulons filetés (27) dirigés vers le capot et fixés à demeure, boulons sur lesquels peuvent être glissées les ailes coudées (31) du capot (22) présentant des forures correspondantes ,
en ce que lors de la pose de l'appareil de climatisation (10) sur la paroi de montage (11), il est mis en place un joint d'étanchéité périphérique (28), tandis que lors de la pose de l'appareil de climatisation (10) dans une découpure (15) de la paroi de montage (11), entre les ailes coudées (25) du soubassement (21) du boîtier et le joint d'étanchéité (28), c'est d'abord la paroi de montage (11) présentant des forures de fixation (14) autour de la découpure (15) qui est assujettie au moyen d'écrous (44) sur les boulons filetés (27), et
en ce que le capot (22) est, au moyen de boulons de fixation (32) à filetage intérieur (45) maintenus à réglage axial limité de manière imperdable dans le capot (22), qui peuvent être vissés sur les boulons filetés (27), relié au soubassement (21) du boîtier.

**2.** Appareil de climatisation suivant la revendication 1,

caractérisé en ce que

lors de la pose, la paroi de montage (11) présente, à côté des forures de fixation (14) pour les éléments de liaison, deux ouvertures de ventilation (12, 13).

3. Appareil de climatisation suivant l'une ou l'autre des revendications 1 et 2,
caractérisé en ce que
dans le fond (23) du soubassement (21) du boîtier , les éléments de liaison ont la forme de rivets filetés (38), dans lesquels sont vissées des goupilles filetées (39), et
en ce que la paroi de montage (11) est, par les forures de fixation (14), glissée sur les goupilles filetées (39) et y est maintenue au moyen d'écrous (40).

4. Appareil de climatisation suivant la revendication 3,
caractérisé
en ce que lors de la pose un joint d'étanchéité périphérique (42) est appliqué sur la paroi de montage (11) entre cette paroi de montage (11) et le soubassement (21) du boîtier.

5. Appareil de climatisation suivant l'une quelconque des revendications de 1 à 4,
caractérisé
en ce que les parois latérales (24) du soubassement (21) du boîtier présentent, en raccordement des ailes (25) dirigées vers l'intérieur, des ailes terminales (26) dirigées vers l'extérieur et parallèlement aux parois latérales (24) , ailes terminales qui chevauchent la région de liaison entre le soubassement (21) du boîtier et le capot (22).

6. Appareil de climatisation suivant l'une quelconque des revendications de 1 à 5,
caractérisé
en ce que la découpure (15) de la paroi de montage (11) est, lors de la pose, adaptée aux dimensions extérieures des ailes terminales (26) des parois latérales (24) du soubassement (21) du boîtier, et
en ce que la position des forures de fixation (14) disposées de la paroi de montage (14) autour de la découpure (15) est harmonisée avec la disposition et la distribution des boulons filetés (27) sur les ailes coudées (25) des parois latérales (24) du soubassement (21) du boîtier.

7. Appareil de climatisation suivant l'une quelconque des revendications de 1 à 6,
caractérisé en ce que lors de la pose de l'appareil, la position des forures de fixation (14) de la paroi de montage (11) est harmonisée avec la position et la distribution des éléments de liaison sous forme de rivets filetés (38) dans le fond (23) du soubassement (21) du boîtier.

8. Appareil de climatisation suivant la revendication 7,
caractérisé en ce que les éléments de liaison sous forme de rivets filetés (38) sont bloqués à l'abri de la perte et de la rotation dans des forures du fond du soubassement (21) du boîtier.

9. Appareil de climatisation suivant l'une quelconque des revendications de 1 à 8,
caractérisé
en ce que les boulons de fixation (32) du capot (22) sont maintenus dans des étriers de guidage en forme de U (33), qui sont fixés sur les faces intérieures des parois latérales (30) du capot (22), les boulons de fixation (32) étant guidés dans des forures des ailes latérales (34, 35) des étriers de guidage (33), et leur liberté de réglage axial étant limitée par des éléments de sécurité (36, 37) montés sur les boulons de fixation (32), et
en ce que dans les faces frontales des boulons de fixation (32) orientées vers le soubassement (21) du boîtier sont pratiqués des filetages intérieurs (45) pour la réception des boulons filetés du soubassement (21) du boîtier.

10. Appareil de climatisation suivant la revendication 9,
caractérisé
en ce que les extrémités (46) des boulons de fixation (32) orientées vers la paroi de recouvrement (29) du capot (22), extrémités (46) présentant une fente, sont accessibles par l'intermédiaire de forures (43) dans la paroi de recouvrement (29).

11. Appareil de climatisation suivant l'une quelconque des revendications de 1 à 10,
caractérisé
en ce que tous les composants, tels que le compresseur, le condenseur, l'évaporateur, les ventilateurs etc. sont logés dans le soubassement (21) du boîtier, et
en ce que dans le capot (22) sont logés mes éléments pour le guidage de l'air, l'épuration de l'air, la natte de filtration et similaires.

12. Appareil de climatisation suivant l'une quelconque que des revendications de 1 à 11,
caractérisé
en ce qu'aux fins de la pose complète dans la découpure (15) de la paroi de montage (11), la paroi de recouvrement (29) présente un bord coudé (58) et la forme d'une pièce indépendante du capot (22),

en ce que la partie restante du capot (22) en forme de cadre présente, en orientation vers la paroi de recouvrement (29) un coude périphérique (49) dirigé vers l'intérieur,

en ce que sur le coude (49) sont montées des goupilles filetées (51) orientées vers la paroi de recouvrement (29), goupilles filetées sur lesquelles est glissée par l'intermédiaire de forures (14) la paroi de montage (11) présentant une découpure (15) correspondante, paroi qui est ensuite assujettie au moyen d'écrous (52),

en ce qu'entre le coude (49) de la paroi de montage (11) et la face intérieure de la paroi de recouvrement (29) est disposé un joint d'étanchéité périphérique (53),

en ce que la paroi de recouvrement (29) est, au moyen d'écrous (54) qui sont vissés sur les tronçons des goupilles filetées (51) émergeant des forures de la paroi de recouvrement (29), solidarisé avec le cadre restant du capot (22) de la paroi de montage (11) (Fig. 9).

13. Appareil de climatisation suivant l'une quelconque des revendications de 1 à 12,
    caractérisé en ce que les boulons de fixation (27) ou goupilles filetées (51) sont constituées par des vis à tête, qui sont introduites à travers des forures du coude (25, 49) du soubassement (21) du boîtier ou du capot (22) et qui par leurs têtes sont soudées à la paroi de recouvrement (29) sur sa face qui est opposée au capot (22) ou à la paroi de recouvrement (29).

14. Appareil de climatisation suivant la revendication 12,
    caractérisé en ce que
    le coude (49) de la partie en forme de cadre du capot (22) présente un tronçon terminal (50), qui est orienté parallèlement aux côtés du cadre et qui recouvre la zone de liaison entre la partie en forme de cadre du capot (22) et la paroi de recouvrement (29).

FIG.1

FIG.2

FIG.3

FIG.4

EP 0 316 654 B1

FIG.5

FIG.6

FIG.8

FIG.7

FIG.9